# EUROPÄISCHE PATENTSCHRIFT

(11) **EP 4 257 991 B1**
(45) Veröffentlichungstag und Bekanntmachung des Hinweises auf die Patenterteilung: **18.02.2026**
(21) Anmeldenummer: 23163067.4
(22) Anmeldetag: 21.03.2023
(51) Int. Cl.: G01R 27/20, G01R 31/52

(54) **AKTIVES ERDUNGSSYSTEM MIT VORAUSSCHAUENDER ÜBERWACHUNG**
ACTIVE GROUNDING SYSTEM WITH LOOK-AHEAD MONITORING
SYSTÈME DE MISE À LA TERRE ACTIF AVEC SURVEILLANCE ANTICIPÉE

(30) Priorität: 01.04.2022 DE 102022107832
(43) Veröffentlichungstag der Anmeldung: 11.10.2023
(73) Patentinhaber: Illinois Tool Works Inc., Glenview IL 60025 (US)
(72) Erfinder: ZIEGLER, Günther, Glenview, Illinois, 60025 (US); HECHT, Matthias, Glenview, Illinois, 60025 (US)
(74) Vertreter: Trinks, Ole

(56) Entgegenhaltungen:
- EP-A1- 3 675 302
- DE-A1- 10 045 439
- US-A1- 2009 153 156
- US-A1- 2012 120 530

## Beschreibung

Die vorliegende Erfindung betrifft ein Erdungssystem zur kontrollierten elektrostatischen Entladung von Behältern, insbesondere Behältern bei denen es zu elektrostatischer Aufladung durch Umgang mit Flüssigkeiten, Granulaten oder Pulvern kommen kann. Insbesondere betrifft die Erfindung ein Erdungssystem mit einer aktiven Erdungsüberwachung. Nach einem weiteren Aspekt betrifft die Erfindung ein Verfahren zur Steuerung eines Erdungssystems zur aktiven Entladung von Behältern.

Beim Umfüllen, Entleeren, Umpumpen, Mischen, Versprühen, Messen, Probenehmen oder Reinigen von Flüssigkeiten, Granulaten oder Pulvern, können sich die dazu gehörigen Behälter oder die Stoffe selbst elektrisch aufladen. Dabei hängt die Höhe der Ladung von einigen Faktoren, wie beispielsweise den Arbeitsverfahren, den Eigenschaften und Strömungsgeschwindigkeiten der zu verarbeitenden Materialien sowie der Größe, Geometrie und Material der Behälter ab.

Durch die oben beschriebene Aufladung von Behältern und/oder Füllstoffen kann es beim Um- und Abfüllen zu ungewollten, unkontrollierten Entladungen kommen, die zu einer Vielzahl von Problemen führen können. Einerseits kann es durch die Entladung zur Behinderung des Umfüll- bzw. Abfüllprozesses kommen. Es gibt jedoch auch gravierendere Folgen: so können elektrische Geräte beschädigt werden, welche mit den Behältern verbunden sind (z.B. elektrische Waagen). Schließlich kann es durch die unkontrollierte Entladung auch zu Bränden kommen, insbesondere bei der Verarbeitung von leicht entflammbaren Materialien.

Um einer derartigen Problematik entgegenzuwirken, ist es bekannt Erdungssysteme einzusetzen, welche eine sichere Erdung und eine damit verbundene, kontrollierte Entladung der Behälter gewährleisten. Generell wird bei derartigen Erdungssystem zwischen aktiven und passiven Systemen unterschieden.

Bei passiven Erdungssystemen handelt es sich um Vorrichtungen, die dazu ausgelegt sind, eine möglichst gute Verbindung (d.h. geringer Widerstand) zwischen dem Behälter und der Erde herzustellen. Die Erdverbindung durch das passive Erdungssystem wird jedoch generell nicht überwacht. Hierzu wurden aktive Erdungssysteme entwickelt. Diese überwachen die Verbindung der Behälter mit dem Potenzialausgleich (z.B. Erde) und den Kontakt der Erdungszangen aktiv. Wird eine ausreichende Erdverbindung erkannt, gibt das aktive Erdungssystem den Um- und Abfüllvorgang frei. Sollte jedoch keine verlässliche Erdverbindung erkennbar sein, können manche, aktive Erdungssysteme den Um- bzw. Abfüllvorgang direkt unterbrechen und somit Schäden vermeiden.

Zwar wird durch die bestehenden Erdungssysteme gewährleistet, dass elektrostatische Ladungen zuverlässig und effektiv abgeleitet und somit Schadensfälle regelmäßig verhindert werden. Jedoch kommt es insbesondere bei aktiven Erdungssystem immer wieder zu Unterbrechungen des Abfüll- bzw. Umfüllvorgangs, wodurch wertvolle Zeit verloren gehen kann. So wird häufig der Um- bzw. Abfüllprozess unterbrochen, sobald das aktive Erdungssystem keine verlässliche Erdung des Behälters erkennt. Der Vorgang ist dabei so lange unterbrochen, bis ein Benutzer den Fehler behebt, wie beispielsweise durch Überprüfung der Kontaktgeber (auch "Erdungszangen"). Erschwerend kommt hinzu, dass nicht jeder Um- bzw. Abfüllvorgang zu jeder Zeit von Benutzern überwacht wird, so dass eine Korrektur der Erdverbindung häufig einige Zeit in Anspruch nimmt und somit zu langen Stillstandzeiten führen kann.

Ein Beispiel für ein solches Erdungssystem mit aktiver Überwachung, das einen Controller sowie einen ersten und einen zweiten Kontaktpunkt umfasst und den gesamten Erdungswiderstand berechnet ist in DE 100 45 439 A1 offenbart.

Auf Grundlage der oben genannten Problemstellung liegt der vorliegenden Erfindung die Aufgabe zu Grunde ein Erdungssystem anzugeben, welches Stillstandzeiten durch unzuverlässige Erdung auf ein Minimum reduziert.

Demgemäß betrifft die vorliegende Erfindung ein Erdungssystem für Behältern, wobei das Erdungssystem eine Steuervorrichtung, einen ersten Kontaktgeber zum elektrischen Verbinden der Steuervorrichtung mit dem Behälter und einen zweiten Kontaktgeber zum Erden des Behälters aufweist. Die Steuervorrichtung ist dazu ausgebildet die folgenden Schritte vorzunehmen:
- Bestimmen eines Kontaktwiderstands zwischen dem ersten und zweiten Kontaktgeber, während diese mit dem Behälter verbunden sind;
- Bestimmen, ob eine unzureichende Erdung des Behälters zu erwarten ist, auf Grundlage des Kontaktwiderstands;
- Erzeugen eines Statussignals, wenn eine unzureichende Erdung des Behälters zu erwarten ist.

Durch das aktive Erdungssystem der vorliegenden Erfindung wird eine vorausschauende Überwachung der Erdung ermöglicht. Insbesondere kann das Erdungssystem der vorliegenden Erfindung eine unzureichende Erdverbindung anhand des Kontaktwiderstands erkennen, bevor diese zu einer Notabschaltung führt. Somit kann das Erdungssystem den Benutzer durch ein entsprechendes Statussignal frühzeitig warnen, so dass dieser entweder eine Notabschaltung verhindern oder bei bereits erfolgter Notabschaltung schneller reagieren kann. Dementsprechend können durch die vorliegende Erfindung Stillstandzeiten verhindert bzw. auf ein Minimum reduziert werden.

Das Erdungssystem ist erfindungsgemäß also dazu ausgebildet eine erhöhte Wahrscheinlichkeit einer zukünftig zu erwartenden unzureichenden Erdung, beispielsweise einer zu erwartenden Notfallabschaltung, zu bestimmen. Das Erdungssystem kann eine derartige erhöhte Wahrscheinlichkeit auf verschiedene Weisen bestimmen. Beispielsweise kann die Bestimmung durch das Erdungssystem insbesondere darin bestehen, dass das Erdungssystem eine Erhöhung der Wahrscheinlichkeit (ohne einen bestimmten prozentualen Anteil zu definieren) erkennt und ein entsprechendes Statussignal (z.B. ein Warnsignal) ausgibt.

Nach einer Ausführungsform der vorliegenden Erfindung ist die Steuervorrichtung dazu ausgebildet, eine bevorstehende, unzureichende Erdung auf Grundlage eines Vergleichs des Kontaktwiderstands mit mindestens einem Warnwiderstand-Schwellwert zu bestimmen. Gemäß dieser Ausführungsform kann das Erdungssystem eine derartig erhöhte Wahrscheinlichkeit für eine Notabschaltung besonders schnell und einfach durch einen Vergleich mit einem Widerstand-Schwellwert bestimmen. Der Warnwiderstand-Schwellwert kann dabei entweder durch den Hersteller vorgegeben oder durch den Benutzer einstellbar sein. Der Warnwiderstand-Schwellwert kann dabei insbesondere auf das Anwendungsgebiet angepasst werden. Alternativ kann der Warnwiderstand-Schwellwert aktiv durch das Erdungssystem bestimmt werden, wie dies später näher erläutert werden wird.

Nach einer weiteren Ausführungsform liegt der mindestens eine Warnwiderstand-Schwellwert zwischen einem Normal-Widerstandswert bei sachgerechter Erdung und einem Notfallwiderstand-Schwellwert bei unzureichender Erdung. Das Erdungssystem muss dementsprechend nicht jede Abweichung des Kontaktwiderstands vom Normal-Widerstandswert als eine Erhöhung der Wahrscheinlichkeit einstufen. Vielmehr kann der Warnwiderstand-Schwellwert eine gewisse Abweichung zum Normalwert erlauben. Bei dem "Normal-Widerstandswert" handelt es sich insbesondere um einen zu erwartenden Widerstandwert bei guter Erdung des Behälters. Beispielsweise kann es sich bei dem Normal-Widerstandswert um einen Mittelwert eines zu erwartenden Widerstandsbereichs handeln.

Nach einer weiteren Ausführungsform ist die Steuervorrichtung dazu ausgebildet, eine Befüllung des Behälters zu unterbrechen oder zu verhindern, falls der Kontaktwiderstand den Notfall-Schwellwert erreicht. Dementsprechend ist der oben genannte Warnwiderstand-Schwellwert zwischen dem zu erwartenden Widerstand und einem Widerstandswert für die Notabschaltung angeordnet.

Nach einer weiteren Ausführungsform ist die Steuervorrichtung dazu ausgebildet, eine bevorstehende, unzureichende Erdung auf Grundlage eines Vergleichs des Kontaktwiderstands mit einem Widerstandsbereich, welcher sich zwischen einem ersten und einem zweiten Warnwiderstand-Schwellwert befindet, zu bestimmen. In einigen Anwendungsfällen ist der oben erwähnte, normale Widerstandswert so gering wie möglich, wobei lediglich eine Erhöhung des Widerstandswerts zu einer Notabschaltung führen kann. Dies ist jedoch nicht immer der Fall. Vielmehr kann auch eine Verringerung des Kontaktwiderstands ein Indiz für eine nicht zureichende Erdung sein. Das Erdungssystem gemäß dieser Ausführungsform kann den Kontaktwiderstand mit einem Widerstandsbereich vergleichen, welcher zwischen einem ersten (oberen) Warnwiderstand-Schwellwert und einem zweiten (unteren) Warnwiderstand-Schwellwert liegt. Mit anderen Worten, der erste, obere Schwellwert liegt oberhalb einem normalen Widerstandswert, während der zweite, untere Schwellwert unterhalb des normalen Widerstandswerts liegt. Dementsprechend kann das Erdungssystem auch ein Abfallen des Widerstandswerts als erhöhte Wahrscheinlichkeit für eine unzureichende Erdung einstufen. Dies ist beispielsweise dann der Fall, wenn ein ungewollter Kurzschluss der Kontaktgeber dazu führt, dass elektrostatische Ladungen des Behälters nicht weiter abgeführt werden können.

Nach einer weiteren Ausführungsform ist die Steuervorrichtung dazu ausgebildet, folgende Schritte vorzunehmen:
- Empfangen von Behälterdaten, welche repräsentativ für den zu füllenden Behälter sind;
- Bestimmen des mindestens einen Warnwiderstand-Schwellwerts auf Grundlage der Behälterdaten.

Gemäß dieser Ausführungsform ist das Erdungssystem automatisch dazu in der Lage, den oder die Warnwiderstand-Schwellwerte auf den Anwendungsfall anzupassen. Das Bestimmen der Behälterdaten kann dabei insbesondere automatisch oder auch durch einen Benutzer erfolgen.

Nach einer weiteren Ausführungsform weisen die Behälterdaten eine oder mehrere der folgenden Daten auf:
- Behältertyp;
- Behälterhersteller;
- Behältermodell;
- Behältergröße;
- Behälterposition.

Der Behältertyp hat einen Einfluss auf die zu erwartenden Widerstandswerte. So wird bei einem Big-Bag ein höherer Kontaktwiderstand erwartet, als es beispielsweise bei einer Metalltonne der Fall ist. Die Steuervorrichtung kann dementsprechend den Widerstands-Schwellwert auf den Behältertyp anpassen. Hierbei spielen auch das Behältermodell sowie der Behälterhersteller eine Rolle. Die Steuervorrichtung kann insbesondere dazu auf eine Datenbank zugreifen, in welcher verschiedene Behälterhersteller und Behältermodelle mit den zu erwartenden Widerstandswerten angegeben sind. Die Steuervorrichtung kann dementsprechend nach automatischer Erfassung des Behältermodells oder Herstellers bzw. nach Eingabe durch den Anwender den zu erwartenden Kontaktwiderstand aus der Datenbank ermitteln.

Auch die Behältergröße und die Behälterposition können einen Einfluss auf den zu erwartenden Widerstand haben. Die Steuervorrichtung kann beispielsweise dazu ausgebildet sein, den Warnwiderstand-Schwellwert linear mit der Behältergröße zu erhöhen bzw. zu erniedrigen.

Auch die Position des Behälters kann bei der Bestimmung des Warnwiderstand-Schwellwerts durch die Steuervorrichtung berücksichtigt werden. Die Position des Behälters wird in der Regel durch den Benutzer an die Steuervorrichtung übergeben. Hierzu kann das Erdungssystem eine Benutzerschnittstelle, wie beispielsweise einen Touchscreen, aufweisen. Die Benutzerschnittstelle kann Vorschläge für herkömmliche Behälterpositionen anbieten. Je nach gewählter Behälterposition kann die Steuervorrichtung sodann den Warnwiderstand-Schwellwert anpassen. Beispielsweise kann die Steuervorrichtung auf eine Datenbank zugreifen, in welcher eine prozentuale Anpassung des Schwellwerts hinterlegt ist, basierend auf verschiedenen Positionen des Behälters (z.B. direkt am Boden oder auf Paletten).

Nach einer weiteren Ausführungsform ist die Steuervorrichtung dazu ausgebildet folgende Schritte vorzunehmen:
- Empfangen von Kontaktgeberdaten, welche repräsentativ für die verwendeten Kontaktgeber sind;
- Bestimmen des mindestens einen Warnwiderstand-Schwellwerts auf Grundlage der Kontaktgeberdaten.

Dabei können die Kontaktgeberdaten die Art der Kontaktgeber, den Kontaktgeberhersteller und/oder das Kontaktgebermodell enthalten. Selbstverständlich haben die Kontaktgeber selbst einen Einfluss auf den zu erwartenden Kontaktwiderstand zwischen den Kontaktgebern. So sind Kontaktklemmen oder Erdungszangen für Erdungssysteme speziell dazu ausgelegt, den Widerstand so gering wie möglich zu halten. Andere Kontaktgeber wie Kontaktspitzen erzielen häufig andere Widerstandswerte. Die Steuervorrichtung gemäß dieser Ausführungsform kann den Warnwiderstands-Schwellwert entsprechend auf die verwendeten Kontaktgeber anpassen. Dazu kann das Erdungssystem eine Benutzerschnittstelle aufweisen, welche dem Benutzer eine Auswahl der verwendeten Kontaktgeber anbietet.

Nach einer weiteren Ausführungsform ist die Steuervorrichtung dazu ausgebildet, eine bevorstehende, unzureichende Erdung auf Grundlage einer zeitlichen Veränderung des Kontaktwiderstands zu bestimmen. Gemäß dieser Ausführungsform speichert die Steuervorrichtung die erfassten Kontaktwiderstände über einen gewissen Zeitraum und vergleicht diese miteinander. Die Steuervorrichtung kann dementsprechend das Derivat des Kontaktwiderstands über die Zeit bilden. Sollte es zu einem unerwartet hohen Anstieg bzw. Abfall des Kontaktwiderstands kommen, so kann die Steuervorrichtung bestimmen, dass die Wahrscheinlichkeit einer unzureichenden Erdung hoch ist und ein entsprechendes Warnsignal ausgeben.

Wie dies später näher erläutert wird, kann die Steuervorrichtung eine bevorstehende, unzureichende Erdung anhand mehrerer Faktoren, wie beispielsweise dem Vergleich mit einem Schwellwert und der zeitlichen Veränderung des Kontaktwiderstands, gleichzeitig bestimmen. Somit kann die Steuervorrichtung ein Warnsignal ausgeben, sobald der Kontaktwiderstand zu schnell steigt oder fällt, ohne jedoch den Schwellwert erreicht zu haben. Dies gibt dem Benutzer die Gelegenheit zu reagieren, bereits bevor der Schwellwert erreicht ist, was insbesondere bei einem sehr starken Anstieg oder Abfall des Kontaktwiderstands zusätzliche Zeit für den Benutzer bedeutet, um eine vorausstehende Notabschaltung zu verhindern.

Nach einem weiteren Aspekt betrifft die vorliegende Erfindung ein Verfahren zur Steuerung eines Erdungssystems zur Entladung von Behältern, insbesondere Erdungssystem mit einer aktiven Erdungsüberwachung, wobei das Verfahren Folgendes aufweist:
- Bestimmen eines Kontaktwiderstands zwischen den Kontaktgebern des Erdungssystems, während diese mit dem Behälter verbunden sind;
- Bestimmen, ob eine unzureichende Erdung des Behälters zu erwarten ist, auf Grundlage des Kontaktwiderstands;
- Bereitstellen eines Statussignals, wenn eine unzureichende Erdung des Behälters zu erwarten ist.

Nachfolgend wird die Erfindung unter Bezugnahme auf die Zeichnungen näher beschrieben.

Dabei zeigen:
- FIG. 1: eine schematische Darstellung eines aktiven Erdungssystems gemäß einer Ausführungsform der vorliegenden Erfindung;
- FIG. 2: eine schematische Darstellung eines aktiven Erdungssystems gemäß einer weiteren Ausführungsform der vorliegenden Erfindung;
- FIG. 3: beispielhaft der Graph der zeitlichen Veränderung des Kontaktwiderstands über die Zeit;
- FIG. 4: beispielhaft der Graph der zeitlichen Veränderung des Kontaktwiderstands über die Zeit;
- FIG. 5: beispielhaft der Graph der zeitlichen Veränderung des Kontaktwiderstands über die Zeit.

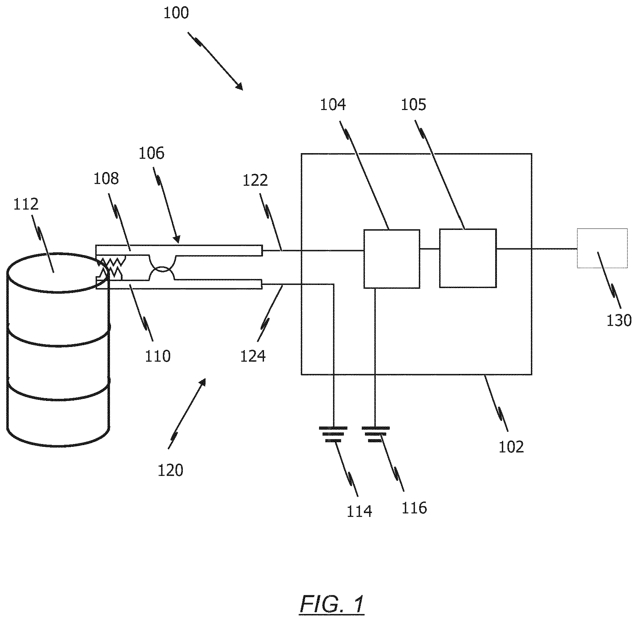

FIG. 1 zeigt eine schematische Darstellung einer Ausführungsform des Erdungssystems gemäß der vorliegenden Erfindung. Das Erdungssystem 100 weist eine Steuervorrichtung 102 auf, welche über eine Kontaktklemme 106 mit einem Behälter 112 elektrisch verbunden ist. Dabei ist der Behälter 112 als Metalltonne, beispielsweise zur Aufnahme von Chemikalien, dargestellt.

Die Kontaktklemme 106 weist einen ersten Kontaktgeber 108 und einen zweiten Kontaktgeber 110 auf. Die ersten und zweiten Kontaktgeber 108, 110 sind Arme der Kontaktklemme 106. Die ersten und zweiten Kontaktgeber 108, 110 sind über die Zähne der Kontaktklemme 106 an dem als Metalltonne 112 ausgebildeten Behälter angebracht und somit über die Wandung des Behälters 112 elektrisch miteinander verbunden.

Der erste Kontaktgeber 108 ist über eine erste Leitung 122 mit der Steuervorrichtung 102 verbunden. Insbesondere ist der erste Kontaktgeber 108 über die erste Leitung 122 mit einer Widerstands-Messeinheit 104 verbunden.

Der zweite Kontaktgeber 110 ist über eine zweite elektrische Leitung 124 mit einem Potentialausgleich, hier einem ersten Erdanschluss 114 verbunden. In der in FIG. 1 gezeigten Darstellung ist der zweite Kontaktgeber 110 insbesondere über die Steuervorrichtung 102 mit dem ersten Erdanschluss 114 verbunden. Dies ist jedoch nicht unbedingt notwendig. Vielmehr kann die zweite elektrische Leitung 124 auch direkt am ersten Erdanschluss 114 angebracht werden.

Die Widerstands-Messeinrichtung 104 ist mit einem zweiten Erdanschluss 116 verbunden. Die Messeinrichtung 104 bildet zusammen mit den beiden Kontaktgebern 108, 110 und den Erdanschlüssen 114, 116 einen eigensicheren Erdungs-Stromkreis aus. Die Steuervorrichtung ist dazu ausgebildet, einen eigensicheren Messstrom über die erste Leitung 122 an den eigensicheren Erdungs-Stromkreis 120 abzugeben. Der eigensichere Strom fließt über den ersten Kontaktgeber 108 und den Behälter 112 zum zweiten Kontaktgeber 110 und zum ersten Erdanschluss 114 über die zweite Leitung 124. Der Stromfluss führt über den zweiten Erdanschluss 116 zurück zur Messeinheit 104.

Die Messeinheit 104 ist dazu ausgelegt, anhand der gemessenen Stromstärke und Spannung einen Gesamtwiderstand des Erdungs-Stromkreises 120 zu messen. Der so ermittelte Gesamtwiderstand, welcher sich insbesondere aus einem Kontaktwiderstand zwischen den Kontaktgebern 108, 110 und einem eventuell auftretenden Widerstand zwischen den Erdanschlüssen 114 und 116 ergibt. Der so gemessene Gesamtwiderstand ist für jeden Anwendungsfall individuell charakterisierend. Dabei ist der Widerstand zwischen den Erdanschlüssen 114, 116 prinzipiell konstant. Lediglich der Widerstand zwischen den Kontaktgebern 108, 110, d.h. der Kontaktwiderstand, variiert, z.B. aufgrund von Korrosion. Die Steuervorrichtung, kann durch eine einmalige Kalibrierung den Widerstand zwischen den Erdanschlüssen 114, 116 festlegen und somit anhand des Gesamtwiderstandes den Kontaktwiderstand ermitteln. Mit anderen Worten, eine Veränderung des Gesamtwiderstands ist ein Maß für die Änderung des Kontaktwiderstands.

Bei der in Figur 1 gezeigten Ausführungsform sollte der Kontaktwiderstand z.B. 100 kΩ nicht überschreiten. Die Steuervorrichtung 102 kann demnach einen Notfallwiderstand-Schwellwert, ab dem es zu einer Notabschaltung kommt, auf 50 kΩ festsetzen.

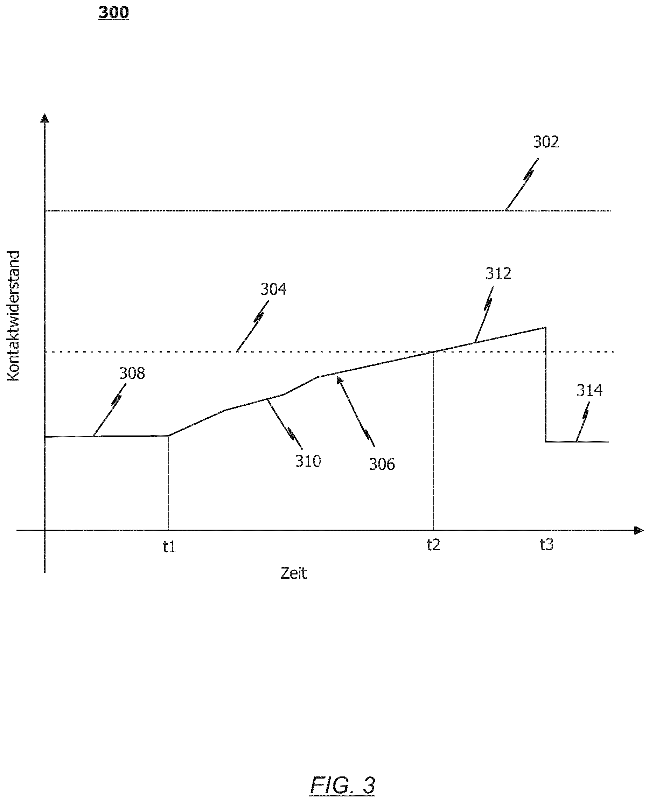

Die Steuervorrichtung 102 weist einen Prozessor 105 auf, welcher dazu ausgebildet ist, eine Wahrscheinlichkeit einer bevorstehenden unzureichenden Erdung, anhand des durch die Messeinheit 104 ermittelten Kontaktwiderstands zu bestimmen. Beispiele zur Bestimmung einer bevorstehenden, unzureichenden Erdung sind in den Figuren 3 bis 5 näher erläutert. Bei einer erhöhten Wahrscheinlichkeit kann der Prozessor 105 ein Statussignal erzeugen, welches von der Steuervorrichtung 102 an den Benutzer ausgegeben werden kann. Hierzu kann der Prozessor der Steuervorrichtung 102 beispielsweise mit einem Warnmelder 130 verbunden oder verbindbar sein. Der Warnmelder 130 kann beispielsweise ein Lautsprecher oder ein Monitor sein, über welchen akustische oder visuelle Warnmeldungen übertragbar sind. Alternativ kann es sich bei dem Warnmelder 130 um eine oder mehrere Leuchten handeln, welche beispielsweise zwischen verschiedenen Farben geändert werden kann, um den Status der Erdung anzuzeigen. Eine erhöhte Wahrscheinlichkeit einer bevorstehenden, unzureichenden Erdung kann dann mit einer der Farben, beispielsweise orange, angezeigt werden. Der Benutzer kann auf die Warnmeldung reagieren und die Erdung überprüfen, bevor ein Notfall eintritt.

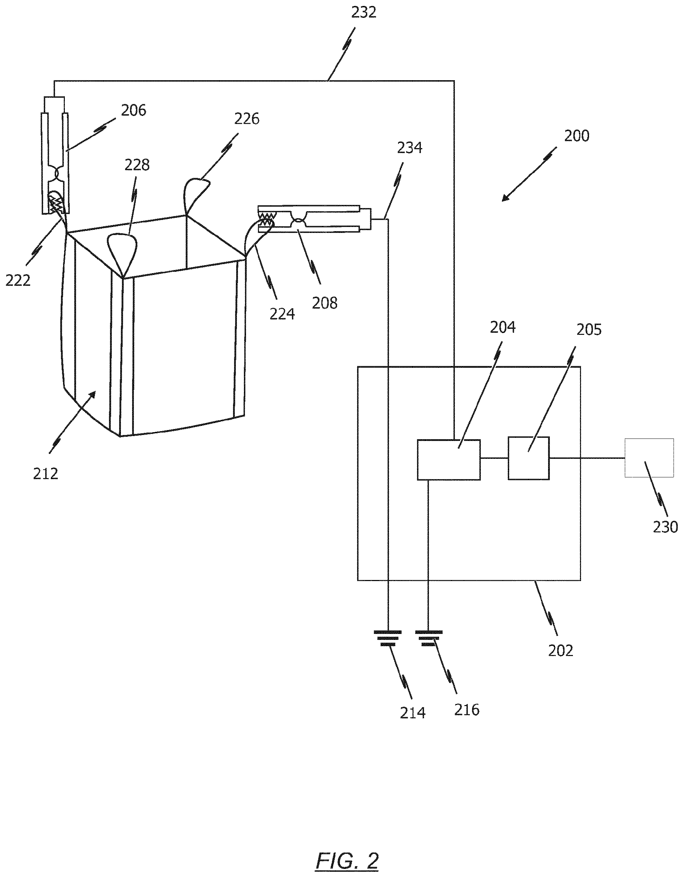

Eine zweite Ausführungsform eines erfindungsgemäßen Erdungssystems 200 ist in der FIG. 2 dargestellt. Das Erdungssystem 200 weist eine Steuervorrichtung 202 mit einer Widerstands-Messeinheit 204 und einem Prozessor 205 auf. Die Steuervorrichtung ist mit einem Warnmelder 230 ausgangsseitig verbunden.

Die Steuervorrichtung 202 ist im Wesentlichen identisch zu der Steuervorrichtung 102 der FIG. 1 ausgebildet. In der FIG. 2 ist die Steuervorrichtung jedoch über zwei als Kontaktklemmen (auch Erdungszangen genannt) 206, 208 ausgebildete Kontaktgeber mit einem Big-Bag-Behälter 212 für Schüttgut verbunden. Der Big-Bag-Behälter 212 weist mehrere Laschen 222, 224, 226, 228 auf, über welche die Kontaktklemmen 206, 208 mit dem Behälter 212 verbunden werden können. Die Laschen 222, 224, 226 228 können ferner zum Heben des Behälters 212 verwendet werden.

Eine erste Kontaktklemme 206 ist mit einer ersten Lasche 222 des Big-Bag-Behälters 212 verbunden. Eine zweite Kontaktklemme 208 ist mit einer zweiten Lasche 224 des Big-Bag-Behälters 212 verbunden. Die beiden Laschen 222, 224 können dabei insbesondere an gegenüberliegenden Enden des Big-Bag-Behälters angeordnet sein.

Die erste Kontaktklemme 206 ist über eine erste Leitung mit der Messeinheit 204 der Steuervorrichtung 202 verbunden. Die zweite Kontaktklemme 208 ist über eine zweite Leitung 234 mit einem ersten Erdanschluss 214 verbunden. Die Messeinheit 204 ist mit einem zweiten Erdanschluss 216 verbunden. Durch diese Anordnung wird zwischen der Messeinheit 204, der ersten Kontaktklemme 206, dem Big-Bag, der zweiten Kontaktklemme 208, dem ersten Erdanschluss 214 und dem zweiten Erdanschluss 216 ein eigensicherer Stromkreis ausgebildet. Die Messeinrichtung 204 kann also dazu verwendet werden, über einen eigensicheren Messstrom den Gesamtwiderstand des eigensicheren Stromkreises zu messen. Im Vergleich zu dem in FIG. 1 dargestellten eigensicheren Stromkreis 120, ist bei sonst gleichen Voraussetzungen zu erwarten, dass der Gesamtwiderstand des eigensicheren Stromkreises nach FIG. 2 einen höheren Wert annimmt, da der Strom von einem Ende des Big-Bag-Behälters 212 zum anderen fließen muss und somit der Kontaktwiderstand zwischen den Kontaktklemmen 206, 208 typischerweise höher ist.

Bei der in Figur 2 gezeigten Ausführungsform sollte der Kontaktwiderstand z.B. 100 MΩ nicht überschreiten. Die Steuervorrichtung 102 kann demnach einen Notfallwiderstand-Schwellwert, ab dem es zu einer Notabschaltung kommt, auf 50 MΩ festsetzen.

Der FIG. 3 ist ein beispielhafter Verlauf des Kontaktwiderstands über die Zeit zu entnehmen. Das Diagramm 300 zeigt einen Notfallwiderstand-Schwellwert 302. Die Steuervorrichtung kann dazu ausgebildet sein, eine Notabschaltung einzuleiten, falls der Kontaktwiderstand den Notfallwiderstand Schwellwert 302 übersteigt. Der Notfallwiderstand-Schwellwert 302 kann durch den Hersteller oder den Benutzer bestimmt werden.

Ein Warnwiderstand-Schwellwert 304 dient der Erkennung einer bevorstehenden, unzureichenden Erdung des mit den Kontaktgebern verbundenen Behälters. Der Warnwiderstand-Schwellwert 304 kann entweder durch den Hersteller oder den Benutzer eingestellt werden oder auch direkt durch den Prozessor bestimmt sein.

Der Verlauf des gemessenen Kontaktwiderstands, also der Widerstand zwischen den Kontaktgebern gemäß diesem Beispiel ist als Funktion 306 dargestellt. In einem ersten Bereich 308 ist der gemessene Kontaktwiderstand im Wesentlichen konstant. Im Ausführungsbeispiel gemäß FIG. 1 kann es sich dabei zum Beispiel um etwa 1 kΩ handeln. Dieser Wert kann auch in der Steuervorrichtung als Normal-Widerstandswert festgelegt sein.

Zum Zeitpunkt t1 beginnt der gemessene Kontaktwiderstand zu steigen. Der zweite Bereich 310 des Graphen 306 zeigt beispielhaft Anstiege des Kontaktwiderstands mit variierenden Steigungen. Ein derartiger Anstieg des Widerstands kann beispielsweise durch Korrosion an den Kontaktgebern entstehen. Andererseits kann ein langsames Abrutschen eines der Kontaktgeber von dem Behälter zu einem langsam steigenden Kontaktwiderstand führen.

Zum Zeitpunkt t2 hat der Kontaktwiderstand den Warnwiderstand-Schwellwert 304 erreicht. Zu diesem Zeitpunkt erkennt die Steuervorrichtung, welche den Kontaktwiderstand kontinuierlich oder in regelmäßigen Abständen mit dem Warnwiderstand-Schwellwert vergleicht, dass der Schwellwert überschritten wurde. Dennoch hat der Kontaktwiderstand zu diesem Zeitpunkt t2 den Notfallwiderstand-Schwellwert 302 noch nicht erreicht, so dass die Erdung noch immer hinreichend ist. Eine Notabschaltung ist nicht notwendig.

Auch in einem dritten Bereich 312 des Graphen 306 verbleibt der Kontaktwiderstand zunächst oberhalb des Warnwiderstand-Schwellwertes 304 und steigt weiter an. Jedoch ist auch im dritten Bereich 312 der Kontaktwiderstand unterhalb des Notfallwiderstand-Schwellwerts 302, so dass der Ab- bzw. Umfüllvorgang auch weiter sicher durchgeführt werden kann. Es bedarf keiner Notabschaltung. Solange sich der Kontaktwiderstand, wie im Bereich 312 gezeigt, oberhalb des Warnwiderstand-Schwellwerts 304 befindet, bestimmt die Steuervorrichtung, dass eine erhöhte Wahrscheinlichkeit besteht, dass eine unzureichende Erdung des Behälters bevorsteht. Die Steuervorrichtung wird in diesem Fall ein Statussignal vom Normalstatus zu einem Warnstatus ändern und den Benutzer entsprechend warnen. Dieser Warnstatus (also ein Warnsignal) wird gemäß diesem Beispiel ab dem Zeitpunkt t2 ausgegeben.

Zum Zeitpunkt t3 hat der Benutzer das Warnsignal erkannt und die Erdung überprüft. Beispielsweise kann der Benutzer die Kontaktgeber wieder neu ausrichten bzw. im Korrosionsfall ersetzen, bevor es zu einer Notabschaltung kommt. Dementsprechend ist der Kontaktwiderstand im Bereich 314 wieder unterhalb des Warnwiderstand-Schwellwerts 304. Der Kontaktwiderstand kann im Bereich 314 vom Kontaktwiderstand im Bereich 308 abweichen, da kleinere Schwankungen bereits durch kleine Unterschiede in der Anbringung der Kontaktgeber verursacht werden.

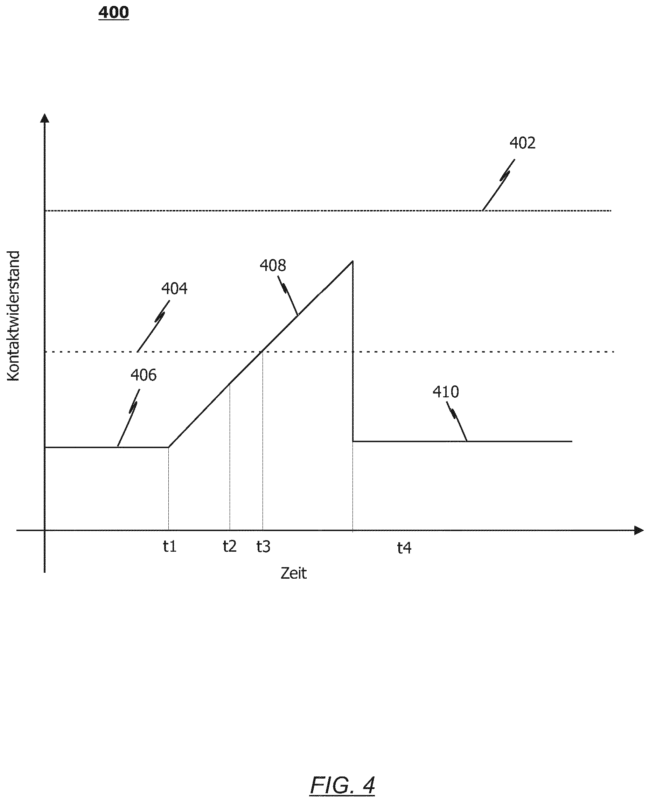

Ein zweites Beispiel eines Widerstandsverlaufs ist der FIG. 4 zu entnehmen. Auch das Diagramm 400 gemäß FIG. 4 zeigt einen Notfallwiderstand-Schwellwert 402 und einen Warnwiderstand-Schwellwert 404. Der Notfallwiderstand-Schwellwert 402 und der Warnwiderstand-Schwellwert 404 können im Wesentlichen den Schwellwerten gemäß FIG. 3 entsprechen. Diese werden beispielsweise durch den Hersteller oder den Benutzer festgelegt bzw. durch die Steuervorrichtung bestimmt.

Auch dem Diagramm 400 gemäß der FIG. 4 sind verschiedene Bereiche 406, 408, 410 zu entnehmen. In einem ersten Bereich 406 ist der Kontaktwiderstand im Wesentlichen konstant und unterhalb dem Warn-Schwellwert 404. Die Steuervorrichtung ist dementsprechend dazu ausgebildet ein Statussignal auszugeben, welches einem Normalzustand, also einer geringen Wahrscheinlichkeit einer bevorstehenden, unzureichenden Erdung entspricht. Zum Zeitpunkt t1 kommt es zu einem relativ starken Anstieg des Kontaktwiderstands über die Zeit. Der Anstieg wird durch einen zweiten Bereich 408 in FIG. 4 gekennzeichnet. Gemäß einer Ausführungsform kann die Steuervorrichtung dazu ausgebildet sein, die Änderung (hier den Anstieg) des Kontaktwiderstands über die Zeit zu bestimmen. Hierzu kann die Steuervorrichtung insbesondere dazu ausgebildet sein, die Kontaktwiderstandswerte über die Zeit zu speichern und miteinander zu vergleichen. Sollte es zu einem starken Anstieg (oder Abfall) des Kontaktwiderstands, wie beispielsweise im Bereich 408, kommen, so kann die Steuervorrichtung bestimmen, dass eine hohe Wahrscheinlichkeit besteht, dass eine unzureichende Erdung des Behälters bevorsteht.

Im Beispiel gemäß FIG. 4 bestimmt die Steuervorrichtung zum Zeitpunkt t2, dass die Änderung des Kontaktwiderstands über die Zeit (zum Beispiel das Derivat der Kontaktwiderstandsfunktion im Bereich 408) über einer vorab festgelegten Steigungsgrenze liegt. Die Steuervorrichtung kann dementsprechend ein Statussignal ausgeben, welches einem Warnstatus/Warnsignal entspricht. Dieses Warnsignal kann bereits zum Zeitpunkt t2 erzeugt werden, d.h. während der absolute Wert des Kontaktwiderstands noch unterhalb des Warnwiderstand-Schwellwerts 404 ist. Somit kann die Steuervorrichtung gemäß dieser Ausführungsform den Benutzer bereits vor Erreichen des Warnwiderstand-Schwellwerts 404 über ein mögliches Problem mit der Erdung informieren.

Erst zum Zeitpunkt t3 übersteigt der Kontaktwiderstand den Warnwiderstand-Schwellwert 404. In manchen Ausführungsformen ist die Steuereinrichtung dazu ausgebildet das Statussignal nicht zu ändern, da dieses bereits zum Zeitpunkt t2 auf ein Warnsignal geschaltet wurde. Jedoch ist es auch denkbar, dass die Steuervorrichtung derart ausgebildet ist, dass ein weiteres Warnsignal erzeugt wird, um den Benutzer noch eindringlicher zu warnen. Beispielsweise könnte eine Farbcodierung dazu dienen, zwischen dem ersten zum Zeitpunkt t2 erzeugten Warnsignal und dem zweiten zum Zeitpunkt t3 erzeugten Warnsignal zu unterscheiden.

Zum Zeitpunkt t4 hat der Benutzer das Warnsignal erkannt und die Erdung überprüft. Dementsprechend ist der Kontaktwiderstand zum Zeitpunkt t4 wieder im normalen Bereich und somit unterhalb dem Widerstand-Schwellwert 404. Die Erdung wurde auch in diesem Beispiel korrigiert, bevor es zu einer Notfallabschaltung kommen musste, wodurch Stillstandzeiten effektiv reduziert werden.

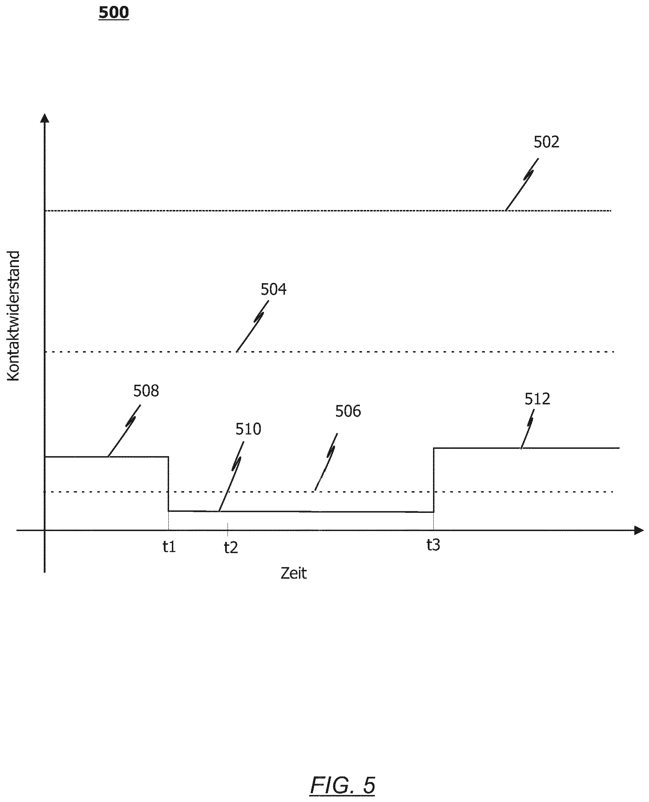

Ein weiteres Beispiel eines Kontaktwiderstandverlaufs ist in der FIG. 5 gezeigt. Das Diagramm 500 gemäß FIG. 5 zeigt den oben bereits erwähnten Notfallwiderstand-Schwellwert 502 und einen ersten Warnwiderstand-Schwellwert 504. Ein zweiter Warnwiderstand-Schwellwert 506 ist ebenfalls in FIG. 5 gezeigt. Dieser befindet sich unterhalb des ersten Warnwiderstand-Schwellenwerts. Der erste Warnwiderstand-Schwellwert 504 ist dementsprechend ein oberer Warnwiderstand-Schwellwert, während der zweite Warnwiderstand-Schwellwert 506 ein unterer Schwellwert ist. Die beiden Warnwiderstand-Schwellwerte 504, 506 bilden einen Widerstandsbereich zwischen sich aus, in welchem die Wahrscheinlichkeit einer unzureichenden Erdung gering ist.

Der Verwendung des zweiten, unteren Warnwiderstand-Schwellwerts 506 liegt der Gedanke zu Grunde, dass der Kontaktwiderstand in manchen Anwendungsfällen (z.B. bei der Ausführungsform gemäß FIG. 2) immer einen gewissen Widerstand aufweist. Sollte dieser dahingegen auf 0 reduziert sein, kann beispielsweise auf einen ungewollten Kurzschluss geschlossen werden.

Der Graph 500 gemäß FIG. 5 weist einen ersten Bereich 508 auf, in welchem sich der Kontaktwiderstand in einem normalen Bereich befindet, bei dem keine Gefahr einer unzureichenden Erdung besteht. Mit anderen Worten, im ersten Bereich befindet sich der Kontaktwiderstand zwischen dem ersten und dem zweiten Warnwiderstand-Schwellwert. Zum Zeitpunkt t1 reduziert sich der Kontaktwiderstand. Dieser liegt nun unter dem von dem Hersteller bzw. dem Benutzer oder der Steuervorrichtung eingerichteten zweiten Warnwiderstand-Schwellwerts 506. Die Steuervorrichtung stellt dies durch einen Vergleich des Kontaktwiderstands mit dem zweiten Warnwiderstand-Schwellwert 506 fest und bestimmt, dass die Wahrscheinlichkeit einer unzureichenden Erdung erhöht ist.

Die Steuervorrichtung kann demnach ein Warnsignal ausgeben, welches den Benutzer darüber informiert, dass es in Kürze zu einer Notabschaltung kommen kann. Es sei jedoch darauf hingewiesen, dass auch der Kontaktwiderstand im Bereich 510 noch immer oberhalb eines Notfallwiderstand-Schwellwerts liegt. Dieser kann in Fig. 5 beispielsweise als 1 Ω festgelegt sein. Mit anderen Worten, selbst in dem Bereich 510 ist die Erdung noch ausreichend und das Be- bzw. Umfüllen kann weiter fortgesetzt werden. Es handelt sich bei dem Warnsignal also lediglich um eine Vorwarnung des Benutzers.

Zum Zeitpunkt t3 hat der Benutzer das Warnsignal erkannt und die Erdung überprüft. Der Kontaktwiderstand ist im Bereich 512 demnach wieder im Normalbereich, so dass das Warnsignal der Steuervorrichtung wieder ausgesetzt werden kann und der Normalzustand angezeigt werden kann.

Die vorliegende Erfindung ist nicht auf die in den Figuren gezeigten Ausführungsformen beschränkt, sondern ergibt sich aus einer Zusammenschau der hierin offenbarten Merkmale. Insbesondere sei noch einmal erwähnt, dass ein Überschreiten der Warnwiderstands-Schwellwerte bzw. eine zu schnelle, zeitliche Veränderung des Kontaktwiderstands nicht direkt zur Notfallabschaltung führt. Vielmehr handelt es sich bei den hier gegebenen Beispielen um Möglichkeiten wie die Steuervorrichtung die Wahrscheinlichkeit einer bevorstehenden, unzureichenden Erdung anhand des Kontaktwiderstands einstufen kann. Der Ab- bzw. Umfüllvorgang kann dementsprechend auch im Warnbereich, d.h. sobald die Steuervorrichtung bestimmt, dass eine erhöhte Wahrscheinlichkeit besteht, dass die Erdung zukünftig nicht mehr hinreichend sein wird, noch immer sicher fortgesetzt werden. Mit anderen Worten, die Steuervorrichtung des hier beschriebenen Erdungssystems handelt mit einem Warnsignal, bevor eine Notfallabschaltung notwendig ist. Das Warnsignal kann also auch von dem Benutzer ignoriert werden ohne Schäden durch unkontrollierte Entladungen zu riskieren.

Die Erfindung ist auch nicht auf die hierin beschriebene Anzahl an Schwellwerten beschränkt. Insbesondere kann eine weitere Abstufung der Warnsignale durch weitere Schwellwerte erzielt werden. So können verschiedene Schwellwerte verschiedene Warnstufen auslösen.

## Patentansprüche

1. Erdungssystem (100), insbesondere Erdungssystem mit einer aktiven Erdungsüberwachung, wobei das Erdungssystem (100) Folgendes aufweist:
- eine Steuervorrichtung (102);
- einen ersten Kontaktgeber (108, 206) zum elektrischen Verbinden der Steuervorrichtung (102) mit einem Behälter;
- einen zweiten Kontaktgeber (110, 208) zum Erden des Behälters (112, 212),
wobei die Steuervorrichtung (102) dazu ausgebildet ist folgende Schritte vorzunehmen:
- Bestimmen eines Kontaktwiderstands zwischen dem ersten und zweiten Kontaktgeber, während diese mit dem Behälter (112, 212) verbunden sind;
- Bestimmen, ob eine unzureichende Erdung des Behälters (112, 212) zu erwarten ist, auf Grundlage des Kontaktwiderstands;
- Erzeugen eines Statussignals, wenn eine unzureichende Erdung des Behälters (112, 212) zu erwarten ist.

2. Erdungssystem (100) nach Anspruch 1,
wobei die Steuervorrichtung (102) dazu ausgebildet ist, eine bevorstehende, unzureichende Erdung auf Grundlage eines Vergleichs des Kontaktwiderstands mit mindestens einem Warnwiderstand-Schwellwert (304, 404, 504, 506) zu bestimmen.

3. Erdungssystem (100) nach Anspruch 2,
wobei der mindestens eine Warnwiderstand-Schwellwert (304, 404, 504, 506) zwischen einem Normal-Widerstandswert bei Normaler Erdung und einem Notfallwiderstand-Schwellwert (302, 402, 502) bei unzureichender Erdung liegt.

4. Erdungssystem (100) nach 3,
wobei die Steuervorrichtung (102) dazu ausgebildet ist, eine Befüllung des Behälters zu unterbrechen oder zu verhindern, falls der Kontaktwiderstand den Notfallwiderstand-Schwellwert (302, 402, 502) erreicht.

5. Erdungssystem (100) nach einem der Ansprüche 2 bis 4,
wobei die Steuervorrichtung (102) dazu ausgebildet ist, eine bevorstehende, unzureichende Erdung auf Grundlage eines Vergleichs des Kontaktwiderstands mit einem Widerstandsbereich, welcher sich zwischen einem ersten und einem zweiten Warnwiderstand-Schwellwert (304, 404, 504, 506) befindet, zu bestimmen.

6. Erdungssystem (100) nach einem der Ansprüche 2 bis 5,
wobei die Steuervorrichtung (102) ausgebildet ist folgende Schritte vorzunehmen:
- Empfangen von Behälterdaten, welche repräsentativ für den zu füllenden Behälter (112, 212) sind;
- Bestimmen des mindestens einen Warnwiderstand-Schwellwerts auf Grundlage der Behälterdaten.

7. Erdungssystem (100) nach Anspruch 6, wobei die Behälterdaten eine oder mehrere der folgenden Daten aufweisen:
- Behältertyp
- Behälterhersteller
- Behältermodell
- Behältergröße
- Behälterposition

8. Erdungssystem (100) nach einem der Ansprüche 2 bis 7,
wobei die Steuervorrichtung (102) ausgebildet ist folgende Schritte vorzunehmen:
- Empfangen von Kontaktgeberdaten, welche repräsentativ für die verwendeten Kontaktgeber (108, 110, 206, 208) sind;
- Bestimmen des mindestens einen Warnwiderstand-Schwellwerts (304, 404, 504, 506) auf Grundlage der Kontaktgeberdaten.

9. Erdungssystem (100) nach Anspruch 8,
wobei die Kontaktelementdaten eine oder mehrere der folgenden Daten aufweisen:
- Art von Kontaktgeber
- Kontaktgeberhersteller
- Kontaktgebermodell

10. Erdungssystem (100) nach einem der Ansprüche 1 bis 7,
wobei die Steuervorrichtung (102) dazu ausgebildet ist, eine bevorstehende, unzureichende Erdung auf Grundlage einer zeitlichen Veränderung des Kontaktwiderstands zu bestimmen.

11. Verfahren zur Steuerung eines Erdungssystems (100) zur kontrollierten elektrostatischen Entladung von Behältern, wobei das Verfahren Folgendes aufweist:
- Bestimmen eines Kontaktwiderstands zwischen Kontaktgebern des Erdungssystems, während diese mit einem Behälter verbunden sind;
- Bestimmen, ob eine unzureichende Erdung des Behälters zu erwarten ist, auf Grundlage des Kontaktwiderstands;
- Bereitstellen eines Statussignals, wenn eine unzureichende Erdung des Behälters zu erwarten ist.

## Claims

1. Grounding system (100), in particular grounding system with active ground monitoring, whereby the grounding system (100) comprises:
- a control apparatus (102);
- a first contact transmitter (108, 206) for electrically connecting the control apparatus (102) to a container;
- a second contact transmitter (110, 208) for grounding the container (112, 212),
wherein the control apparatus (102) is configured in order to perform the following steps:
- determining a contact resistance between the first and second contact transmitters while they are connected to the container (112, 212);
- determining whether an insufficient grounding of the container (112, 212) is anticipated based on the contact resistance;
- generating a status signal when an insufficient grounding of the container (112, 212) is anticipated.

2. The grounding system (100) according to claim 1,
wherein the control apparatus (102) is configured in order to determine an impending insufficient grounding based on a comparison of the contact resistance to at least one warning resistance threshold (304, 404, 504, 506).

3. The grounding system (100) according to claim 2,
wherein the at least one warning resistance threshold (304, 404, 504, 506) is between a normal resistance value in case of normal grounding and an emergency resistance threshold (302, 402, 502) in case of insufficient grounding.

4. The grounding system (100) according to claim 3,
wherein the control apparatus (102) is configured in order to interrupt or prevent a filling of the container if the contact resistance reaches the emergency resistance threshold (302, 402, 502).

5. The grounding system (100) according to any one of claims 2 to 4,
wherein the control apparatus (102) is configured in order to determine an impending insufficient grounding based on a comparison of the contact resistance to a resistance range between a first and a second warning resistance threshold (304, 404, 504, 506).

6. The grounding system (100) according to any one of claims 2 to 5,
wherein the control apparatus (102) is configured in order to perform the following steps:
- receiving container data that is representative of the container to be filled (112, 212);
- determining the at least one warning resistance threshold based on the container data.

7. The grounding system (100) according to claim 6, wherein the container data comprises one or more of the following data:
- Container type
- Container manufacturer
- Container model
- Container size
- Container position

8. The grounding system (100) according to any one of claims 2 to 7,
wherein the control apparatus (102) is configured in order to perform the following steps:
- receiving contact transmitter data that is representative of the contact transmitter (108, 110, 206, 208) used;
- determining the at least one warning resistance threshold (304, 404, 504, 506) based on the contact transmitter data.

9. The grounding system (100) according to claim 8,
wherein the contact transmitter data comprises one or more of the following data:
- Type of contact transmitter
- Contact transmitter manufacturer
- Contact transmitter model

10. The grounding system (100) according to any one of claims 1 to 7, wherein the control apparatus (102) is configured in order to determine an impending, insufficient grounding based on a temporal change of the contact resistance.

11. A method of controlling a grounding system (100) for controlled electrostatic discharge of containers, wherein the method comprises the following:
- determining a contact resistance between contact transmitters of the grounding system while they are connected to the container;
- determining whether an insufficient grounding of the container is anticipated based on the contact resistance;
- providing a status signal when an insufficient grounding of the container is anticipated.

## Revendications

1. Système de mise à la terre (100), en particulier système de mise à la terre avec surveillance active de la terre, dans lequel le système de mise à la terre (100) comprend :
- un appareil de commande (102) ;
- un premier transmetteur de contact (108, 206) pour connecter électriquement l'appareil de commande (102) à un récipient ;
- un deuxième transmetteur de contact (110, 208) pour la mise à la terre du récipient (112, 212),
dans lequel l'appareil de commande (102) est configuré afin de réaliser les étapes suivantes :
- la détermination d'une résistance de contact entre les premier et deuxième transmetteurs de contact alors qu'ils sont connectés au récipient (112, 212) ;
- le fait de déterminer si une mise à la terre insuffisante du récipient (112, 212) est anticipée sur la base de la résistance de contact ;
- la génération d'un signal d'état lorsqu'une mise à la terre insuffisante du récipient (112, 212) est anticipée.

2. Système de mise à la terre (100) selon la revendication 1,
dans lequel l'appareil de commande (102) est configuré afin de déterminer une mise à la terre insuffisante imminente sur la base d'une comparaison de la résistance de contact à au moins un seuil de résistance d'avertissement (304, 404, 504, 506).

3. Système de mise à la terre (100) selon la revendication 2,
dans lequel l'au moins un seuil de résistance d'avertissement (304, 404, 504, 506) est entre une valeur de résistance normale dans le cas d'une mise à la terre normale et un seuil de résistance d'urgence (302, 402, 502) dans le cas d'une mise à la terre insuffisante.

4. Système de mise à la terre (100) selon la revendication 3,
dans lequel l'appareil de commande (102) est configuré afin d'interrompre ou d'empêcher un remplissage du récipient si la résistance de contact atteint le seuil de résistance d'urgence (302, 402, 502).

5. Système de mise à la terre (100) selon l'une quelconque des revendications 2 à 4,
dans lequel l'appareil de commande (102) est configuré afin de déterminer une mise à la terre insuffisante imminente sur la base d'une comparaison de la résistance de contact à une plage de résistances entre un premier et un deuxième seuil de résistance d'avertissement (304, 404, 504, 506).

6. Système de mise à la terre (100) selon l'une quelconque des revendications 2 à 5,
dans lequel l'appareil de commande (102) est configuré afin de réaliser les étapes suivantes :
- la réception de données de récipient qui sont représentatives du récipient à remplir (112, 212) ;
- la détermination de l'au moins un seuil de résistance d'avertissement sur la base des données de récipient.

7. Système de mise à la terre (100) selon la revendication 6, dans lequel les données de récipient comprennent une ou plusieurs parmi les données suivantes :
- Type du récipient
- Fabricant du récipient
- Modèle du récipient
- Taille du récipient
- Position du récipient

8. Système de mise à la terre (100) selon l'une quelconque des revendications 2 à 7,
dans lequel l'appareil de commande (102) est configuré afin de réaliser les étapes suivantes :
- la réception de données de transmetteur de contact qui sont représentatives du transmetteur de contact (108, 110, 206, 208) utilisé ;
- la détermination de l'au moins un seuil de résistance d'avertissement (304, 404, 504, 506) sur la base des données de transmetteur de contact.

9. Système de mise à la terre (100) selon la revendication 8,
dans lequel les données de transmetteur de contact comprennent une ou plusieurs parmi les données suivantes :
- Type du transmetteur de contact
- Fabricant du transmetteur de contact
- Modèle du transmetteur de contact

10. Système de mise à la terre (100) selon l'une quelconque des revendications 1 à 7,
dans lequel l'appareil de commande (102) est configuré afin de déterminer une mise à la terre insuffisante imminente sur la base d'un changement temporel de la résistance de contact.

11. Procédé de commande d'un système de mise à la terre (100) pour une décharge électrostatique commandée de récipients, dans lequel le procédé comprend ce qui suit :
- la détermination d'une résistance de contact entre des transmetteurs de contact du système de mise à la terre alors qu'ils sont connectés au récipient ;
- le fait de déterminer si une mise à la terre insuffisante du récipient est anticipée sur la base de la résistance de contact ;
- la fourniture d'un signal d'état lorsqu'une mise à la terre insuffisante du récipient est anticipée.
